# DEMANDE DE BREVET EUROPEEN

(11) **EP 1 622 203 A2**
(43) Date de publication de la demande: **01.02.2006**
(21) Numéro de dépôt: 05366004.9
(22) Date de dépôt: 02.06.2005
(51) Int. Cl.: H01L 29/78, H01L 21/336, H01L 29/45, H01L 29/49

(54) **Transistor DMOS et méthode de fabrication correspondante.**

(30) Priorité: 07.06.2004 FR 0406092
(71) Demandeur: STMicroelectronics S.A., 92120 Montrouge (FR)
(72) Inventeur: Szelag, Bertrand, Novagraaf Tech. - Cabinet Ballot, 57070 Metz (FR)
(74) Mandataire: Bouchet, Geneviève

(57) **Abrégé**

L'invention concerne un procédé de réalisation d'un transistor DMOS à extension latérale de drain au cours duquel on dépose sur un substrat une grille (21, 22, 53) présentant deux faces latérales sensiblement parallèles, puis on dépose, par photolithographie, un espaceur de drain (24 et 34, 26 et 36, 51) et un espaceur de source (25 et 35, 27 et 37, 52) en matériau isolant sur les faces latérales de la grille, respectivement côté drain et côté source du transistor. L'invention concerne également un transistor obtenu selon le procédé ci-dessus.

Selon l'invention, l'espaceur de drain a une largeur strictement supérieure à une largeur de l'espaceur de source, et on choisit de préférence une largeur de l'espaceur de drain supérieure à une incertitude absolue sur les dimensions d'une résine nécessaire à la réalisation d'une photolithographie. Ceci est par exemple obtenu en réalisant côté drain un espaceur primaire (24, 26), puis un espaceur secondaire (34, 36) venant recouvrir l'espaceur primaire.

## Description

L'invention concerne un procédé de fabrication d'un transistor DMOS à extension latérale de drain et un transistor DMOS associé. Plus précisément, l'invention concerne un procédé de réalisation d'un transistor DMOS à extension latérale de drain au cours duquel on dépose sur un substrat une grille présentant deux faces latérales sensiblement parallèles, puis on définit un espaceur de drain et un espaceur de source en matériau isolant sur les faces latérales de la grille, respectivement côté drain et côté source du transistor.

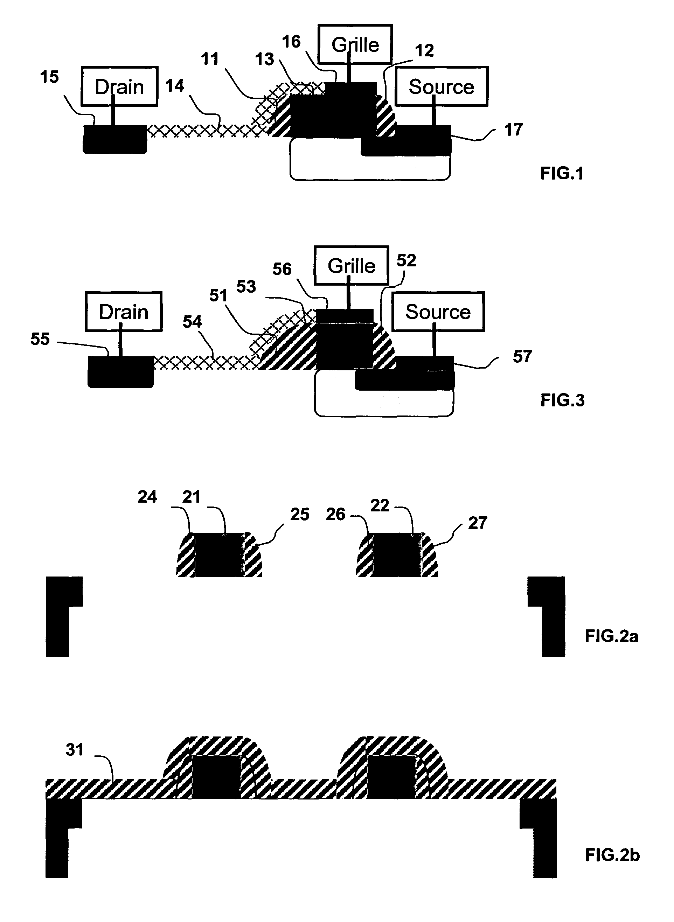

Un tel procédé de réalisation est actuellement bien connu et permet de réaliser des transistors DMOS tel que celui représenté schématiquement sur la figure 1. Ce transistor présente une distance importante entre le drain et la grille (d'où l'expression "extension latérale de drain"), qui lui permet de tenir des tensions importantes sur son drain.

De manière plus détaillée, pour réaliser un transistor DMOS, on forme tout d'abord une grille en polysilicium sur un substrat en silicium de type approprié, par une étape de photolithographie, qui comprend le dépôt d'une couche de matériau de grille, par exemple du polysilicium, puis le dépôt d'une couche de résine sur cette couche de polysilicium. Après définition de la géométrie de la grille à l'aide d'un masque, on retire localement la résine et on grave les régions ainsi découvertes de polysilicium de façon à obtenir la grille du transistor après retrait de la résine. Le canal du transistor est réalisé par une implantation de dopants d'espèce de type approprié auto alignée à la grille, coté source. La zone à implanter est définie par une étape de photolithographie. La diffusion des dopants sous la grille définit la longueur du canal.

Deux espaceurs sont ensuite gravés de part et d'autre de la grille dans un matériau isolant. Le matériau isolant utilisé comprend par exemple une fine couche d'oxyde de silicium recouverte d'une couche de nitrure, la couche d'oxyde servant essentiellement de couche d'arrêt au moment de la gravure du nitrure.

Les espaceurs sont des éléments bien connus dans la réalisation des transistors, notamment des transistors MOS. Ce sont des éléments isolants, positionnés de manière symétrique de part et d'autre de la grille. Ils sont identiques côté drain et côté source et s'étendent en général depuis une face latérale de la grille dans la direction de la source ou du drain. Ils ont pour fonction d'éviter de mettre en court-circuit la grille et le drain ou la grille et la source lors de la formation du siliciure lors de la formation des contacts électriques métalliques du transistor. On trouve de tels espaceurs par exemple dans le document US 4,891,326.

Une étape d'implantation est réalisée ensuite, pour former le drain et la source du transistor de part et d'autre de la grille. Pour cela, on redépose une couche de résine que l'on retire localement après un masquage spécifique d'implantation pour découvrir la zone du substrat comportant le transistor DMOS puis on procède à l'implantation de dopants appropriés dans cette zone de façon à réaliser des zones implantées. Coté source, les dopants, implantés de façon auto alignée à la grille, vont diffuser sous cette dernière. Coté drain, l'implantation n'est pas réalisée près de la grille, la distance entre le drain et la grille constituant l'extension de DMOS qui définit la tenue en tension .

vient ensuite une étape de métallisation pour réaliser des contacts métalliques destinés à connecter le drain, la grille et la source du transistor à des circuits externes. Pour cela, on dépose tout d'abord par photolithographie une couche de protection (par exemple du nitrure) sur les surfaces conductrices en silicium ou polysilicium qui ne doivent pas être métallisées, notamment la région entre le drain et la grille. On vient ensuite déposer un composé métallique (contenant par exemple du Titane, du nickel ou du cobalt) sur les régions découvertes, métal qui réagit avec le silicium (réaction de siliciuration) au niveau du drain, de la grille et de la source pour former des contacts métalliques.

Un exemple de transistor résultant de ce procédé est représenté sur la figure 1. Les espaceurs 11, 12 de part et d'autre de la grille 13 ont une largeur au pied d'environ 0.1µm. Une distance d'environ 0.5 à 1µm sépare le contact de drain 15 et le polysilicium formant la grille 13, cette distance étant fonction de la tenue en tension souhaitée pour le transistor. Le contact de grille 16, surface active de la grille, a une largeur d'environ 0.3µm, définie en fonction des propriétés souhaitées de la grille 13. Le polysilicium formant la grille a quant à lui une largeur de l'ordre de 0.5µm.

On remarque que la couche de protection 14, destinée à empêcher la siliciuration dans les régions non souhaitées lors de la formation des contacts 15, 16, 17, s'étend largement : elle recouvre l'espaceur côté drain 11 et en partie le polysilicium formant la grille 13. Ceci est du à l'incertitude sur la dimension d'une couche de résine nécessaire à la réalisation de la couche de protection 14 dans les zones appropriées par photolithographie.

En effet, comme dit précédemment, l'étape de métallisation des contacts est précédée d'une étape de photolithographie visant à déposer une couche de protection sur les zones où une métallisation est susceptible de se produire mais n'est pas souhaitée, notamment la région entre le drain et la grille. Cette étape de dépôt de la couche de protection comprend le dépôt sur toute la surface du circuit d'une couche de matériau de protection (par exemple un matériau isolant tel qu'un nitrure), puis le dépôt d'une couche de résine sur la couche de matériau de protection. Après définition à l'aide d'un masque de la géométrie des zones à protéger, on retire localement la résine et on grave les régions ainsi découvertes de la couche de matériau de protection de façon à obtenir après retrait de la résine une couche de protection 14 uniquement sur les zones où une métallisation n'est pas souhaitée.

La définition des zones à protéger passe ainsi par le dépôt / gravage d'une couche de résine. Or, les procédés connus de réalisation d'une telle étape ne permettent pas d'obtenir une précision supérieure à 0.2µm en largeur absolue. Ainsi, pour garantir que toute la zone de silicium entre la zone de contact de drain et la grille est effectivement protégée par une couche de protection, il est nécessaire que cette couche de protection s'étende 0.2µm au-delà de la limite souhaitée. Cette couche 14 recouvre ainsi l'espaceur côté drain et une partie de la grille en polysilicium de largeur environ 0.2µm. Pour obtenir un contact de grille 16 de l'ordre de 0.3µm, il est ainsi nécessaire de prévoir une grille 13 de polysilicium de l'ordre de 0.5µm. D'où un encombrement important.

Par ailleurs, la zone de polysilicium recouverte par la couche de protection induit une capacité parasite entre la grille et le drain du transistor qui pénalise les performances dynamiques du transistor, notamment sa fréquence de transition.

L'invention a pour but de réaliser un transistor DMOS ne présentant pas ces inconvénients, et plus précisément de proposer un transistor DMOS à extension latérale de drain de largeur réduite et présentant de meilleures performances dynamiques par rapport aux transistors DMOS existants.

Ce but est atteint par un procédé selon l'invention, au cours duquel on réalise un espaceur de drain plus large que l'espaceur de source, et de préférence de largeur supérieure à l'incertitude absolue sur une dimension d'une couche de résine nécessaire à la réalisation d'une photolithographie. Par exemple, la largeur de l'espaceur de source est de l'ordre de 0.1µm et la largeur de l'espaceur de drain est de l'ordre de 0.2 à 0.3µm.

Avec un tel espaceur de drain, il est possible de déposer, avant siliciuration, une couche de résine protectrice entre le drain et la grille qui recouvre uniquement la zone entre le drain et la grille mais de déborde pas sur la grille elle-même. Le contact de grille réalisé ensuite peut ainsi recouvrir toute la surface de la grille. Avec l'invention, il est ainsi possible de réduire la largeur de la grille comme on le verra mieux par la suite, ce qui permet de réduire la largeur globale du transistor.

Selon un mode préféré de mise en oeuvre, pour réaliser un espaceur de drain de largeur supérieure à la largeur de l'espaceur de source, on réalise les sous-étapes suivantes :
- on dépose, sur les faces latérales de la grille, un espaceur primaire de drain et un espaceur primaire de source de même largeur,
- on dépose un espaceur secondaire de drain et un espaceur secondaire de source, respectivement au dessus de l'espaceur primaire de drain et au-dessus de l'espaceur primaire de source, de sorte à recouvrir l'espaceur primaire de drain et l'espaceur primaire de source,
- on ôte l'espaceur secondaire de source.

Le dépôt des espaceurs primaires, le dépôt des espaceurs secondaires et l'enlèvement de l'espaceur secondaire de source sont réalisés de préférence par photolithographie.

L'invention concerne également un transistor obtenu selon le procédé décrit ci-dessus.

D'autres caractéristiques et avantages de l'invention ressortiront clairement de la description qui est faite ci-après d'un mode préféré de mise en oeuvre d'un procédé de fabrication d'un transistor DMOS, selon l'invention. Cette description est faite à titre indicatif et nullement limitatif, en référence aux dessins annexés, dans lesquels :
- la figure 1, déjà décrite, représente schématiquement un transistor DMOS connu,
- les figures 2a à 2g schématisent les résultats des différentes étapes d'un procédé selon l'invention, et
- la figure 3 représente schématiquement un transistor obtenu selon le procédé de l'invention.

Les figures 2a à 2g présentent les différentes étapes spécifiques à l'invention et nécessaires à la réalisation de deux transistors DMOS à extension latérale.

Pour réaliser des transistors selon l'invention, des grilles 21, 22 sont tout d'abord réalisées sur le substrat de silicium par une étape de photolithographie connue. Des espaceurs primaires 24, 25, 26, 27 sont ensuite réalisés de part et d'autre des grilles dans un matériau isolant. Les espaceurs primaires côté drain et côté source sont de même largeur (figure 2a).

Selon l'invention, les espaceurs primaires côté drain 24, 27 sont ensuite élargis de la manière suivante.

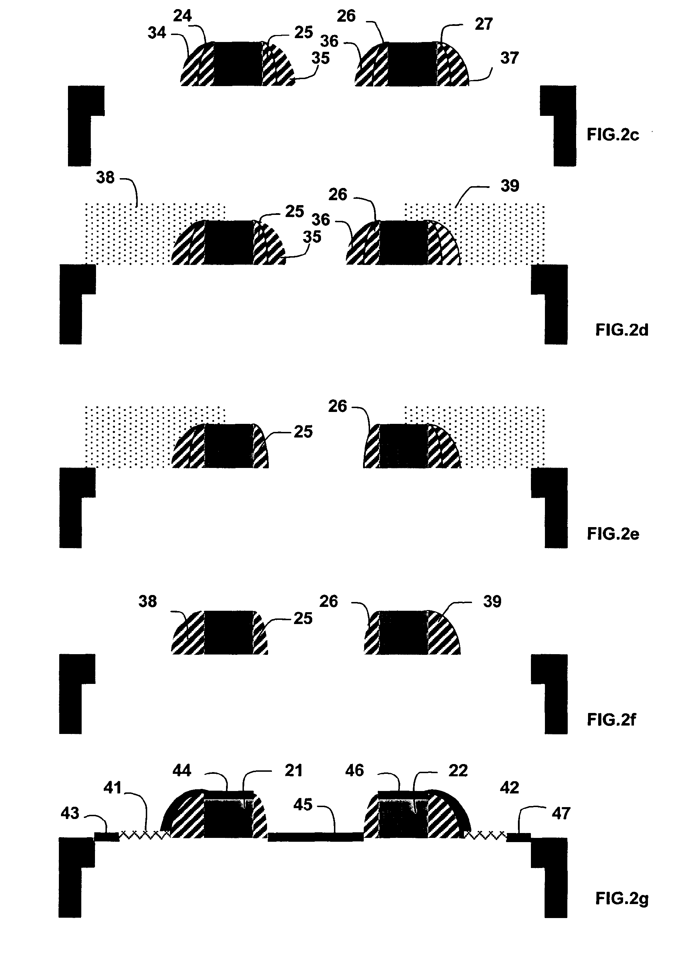

Une fine couche d'oxyde est déposée sur le substrat, les espaceurs primaires et les grilles, puis recouverte d'une couche de nitrure 31 (figure 2b). La couche d'oxyde et la couche 31 forment ensemble une couche de matériau isolant, la couche d'oxyde étant utilisée comme couche d'arrêt pour l'étape de gravure suivante au cours de laquelle des espaceurs secondaires 34, 35, 36, 37 (figures 2c) sont formés par dessus les espaceurs primaires 24, 25, 26, 27 dans la couche de nitrure 31 : dépôt d'une couche de nitrure d'épaisseur suffisante pour réaliser des espaceurs de la largeur souhaitée, puis gravure du nitrure pour réaliser les espaceurs secondaires 34, 35, 36, 37.

Les espaceurs secondaires 35, 36 côté source sont ensuite supprimés par une photolithographie. Pour cela, une couche protectrice de résine est déposée sur les espaceurs secondaires côté drain 34, 37 (figure 2d) et les espaceurs secondaires côté source 35, 36 sont supprimés par une gravure du nitrure qui les constitue (figure 2e). La résine est ensuite enlevée (figure 2f).

On obtient ainsi pour chaque transistor un espaceur côté drain 38, 39 (constitué d'un espaceur primaire recouvert d'un espaceur secondaire) plus large que l'espaceur côté source 25, 26. On notera que les espaceurs primaires et secondaires n'ont pas nécessairement la même largeur. La largeur des espaceurs primaires est choisie sur les mêmes critères que pour des transistors connus, notamment en fonction de la distance souhaitée entre la grille et la source. La largeur des espaceurs secondaires est choisie de sorte que la largeur des espaceurs résultant côté drain soit supérieure à l'incertitude absolue sur la définition des dimensions d'une couche de résine utilisée ensuite pour la réalisation des contacts métalliques. A titre d'exemple, on pourra choisir des espaceurs côté source de l'ordre de 0.1 µm et des espaceurs côté drain de l'ordre de 0.2 à 0.3 µm.

Une étape d'implantation appropriée connue (non représentée sur les figures 2a à 2g) est réalisée ensuite, pour former le drain et la source du transistor de part et d'autre de la grille selon la méthode connue et décrite précédemment.

Vient ensuite une étape de métallisation pour réaliser des contacts métalliques destinés à connecter le drain, la grille et la source du transistor à l'extérieur. Pour cela, on dépose tout d'abord par photolithographie une couche de protection 41, 42 (par exemple du nitrure) sur les surfaces conductrices en silicium ou polysilicium qui ne doivent pas être métallisées. La couche de protection 41, 42 recouvre les régions entre le drain et la grille de chaque transistor, mais n'empiète pas sur les grilles 21, 22 en polysilicium. Les contacts sont ensuite réalisés comme par le passé : on vient déposer un composé métallique (Titane, nickel, cobalt, etc.) sur les régions découvertes, métal qui réagit avec le silicium (réaction de siliciuration) au niveau du drain, de la grille et de la source pour former des contacts métalliques. Après réalisation des contacts, la résine est enlevée.

Le transistor résultant du procédé décrit ci-dessus est représenté schématiquement sur la figure 3. Par rapport à un transistor DMOS selon la figure 1, ses principales caractéristiques sont :
- un espaceur de drain 51 plus grand que son espaceur de source 52, la largeur de l'espaceur de drain étant choisie supérieure à l'incertitude absolue sur le dimensionnement d'une couche de résine utilisée dans le cadre d'une photolithographie ; à titre d'exemple, la largeur de l'espaceur de source est de l'ordre de 0.1µm et la largeur de l'espaceur de drain est de l'ordre de 0.2 à 0.3µm,
- un contact de grille 54 dont la largeur de même largeur que la grille 53 en polysilicium qu'il recouvre et une grille de taille réduite à la largeur souhaitée du recouvrement par le contact de grille ceci permet un gain de l'ordre de 10 à 20 % sur la largeur du transistor ; on obtient ainsi un transistor ayant de bonnes performances dynamiques.

On notera que, malgré l'utilisation d'un espaceur de drain plus large que l'espaceur de source, la distance entre le drain et la grille reste inchangée et dépend uniquement de la tenue en tension souhaitée pour le transistor.

Les espaceurs de drain ou de source et la couche de protection 41, 42 peuvent être réalisés dans le même matériau isolant, constitué par exemple d'une fine couche d'oxyde déposé et d'une couche de nitrure.

## Revendications

1. Procédé de réalisation d'un transistor DMOS à extension latérale de drain au cours duquel on dépose sur un substrat une grille (21, 22, 53) présentant deux faces latérales sensiblement parallèles, puis on définit un espaceur de drain (24 et 34, 26 et 36, 51) et un espaceur de source (25 et 35, 27 et 37, 52) en matériau isolant sur les faces latérales de la grille, l'espaceur de drain et l'espaceur de source s'étendant respectivement côté drain et côté source du transistor, le procédé étant **caractérisé en ce que** l'espaceur de drain a une largeur strictement supérieure à une largeur de l'espaceur de source.

2. Procédé selon la revendication 1, dans lequel la largeur de l'espaceur de drain est supérieure à une incertitude absolue sur une dimension d'une couche de résine nécessaire à la réalisation de la photolithographie.

3. Procédé selon la revendication 1 ou 2, dans lequel la largeur de l'espaceur de source est de l'ordre de 0.1µm et la largeur de l'espaceur de drain est de l'ordre de 0.2 à 0.3µm.

4. Procédé selon la revendication 1 dans lequel le dépôt de l'espaceur de drain et de l'espaceur de source comprend les sous-étapes suivantes consistant à :
• déposer, sur les faces latérales de la grille, un espaceur primaire de drain (24, 26) et un espaceur primaire de source (25, 27) de même largeur,
• déposer un espaceur secondaire de drain (34, 36) et un espaceur secondaire de source (35, 37), respectivement au dessus de l'espaceur primaire de drain (24, 26) et au-dessus de l'espaceur primaire de source (25, 27), de sorte à recouvrir l'espaceur primaire de drain et l'espaceur primaire de source,
• ôter l'espaceur secondaire de source.

5. Procédé selon la revendication 4 dans lequel le dépôt des espaceurs primaires, le dépôt des espaceurs secondaires et l'enlèvement de l'espaceur secondaire de source sont réalisés par photolithographie.

6. Procédé selon l'une des revendications précédentes, au cours duquel on réalise ensuite, au dessus de la grille, un contact de grille (44, 46) de largeur approximativement égale à la largeur de la grille (21, 22).

7. Procédé selon la revendication 6 dans lequel, pour réaliser le contact de grille :
• on dépose une couche de protection contre une siliciuration sur l'espaceur de drain et sur une zone de substrat comprise entre l'espaceur de drain et le drain,
• on forme le contact de grille par siliciuration des zones de substrat non protégées par la couche de protection.

8. Transistor de type DMOS à extension latérale de drain comprenant une grille (53) déposée au dessus d'un substrat, un espaceur de drain (51) et un espaceur de source (52) disposés sur des faces latérales de part et d'autre de la grille, respectivement côté source et côté drain, **caractérisé en ce que** l'espaceur de drain a une largeur strictement supérieure à une largeur de l'espaceur de source.

9. Transistor selon la revendication 8, dans lequel la largeur de l'espaceur de drain est supérieure à une incertitude absolue sur des dimensions d'une couche de résine protectrice nécessaire pour la mise en oeuvre d'une étape de photolithographie sur un substrat de silicium.

10. Transistor selon la revendication 9, dans lequel la largeur de l'espaceur de drain est égale à deux à trois fois la largeur de l'espaceur de source.

11. Transistor selon l'une des revendications 8 ou 9, dans lequel l'espaceur de drain et une zone de substrat compris entre l'espaceur de drain et le drain sont recouverts d'une couche de protection (54) contre une siliciuration.

12. Transistor selon la revendication 11, dans lequel la couche de protection (54) ne s'étendant pas au dessus de la grille (53).

13. Transistor selon l'une des revendications 8 à 12, comprenant également, au dessus de la grille, un contact de grille (56) de largeur sensiblement égale à la largeur de la grille (53).
